Europäisches Patentamt

European Patent Office

Office européen des brevets

(19)

(11) Veröffentlichungsnummer: **0 161 398**
**B1**

(12) **EUROPÄISCHE PATENTSCHRIFT**

(45) Veröffentlichungstag der Patentschrift:
**13.07.88**

(51) Int. Cl.⁴: **G 01 R 31/36, H 01 M 10/52**

(21) Anmeldenummer: **85101819.2**

(22) Anmeldetag: **20.02.85**

(54) Vorrichtung zur Anzeige des Volladezustandes eines elektrischen Akkumulators.

(30) Priorität: **18.04.84 DE 3414664**

(43) Veröffentlichungstag der Anmeldung:
**21.11.85 Patentblatt 85/47**

(45) Bekanntmachung des Hinweises auf die Patenterteilung:
**13.07.88 Patentblatt 88/28**

(84) Benannte Vertragsstaaten:
**AT BE CH DE FR GB IT LI NL SE**

(56) Entgegenhaltungen:
**DE - A - 2 638 899**
**DE - A - 2 725 661**
**DE - A - 3 018 305**
**GB - A - 2 042 242**
**US - A - 3 102 220**

(73) Patentinhaber: **VARTA Batterie Aktiengesellschaft, Am Leineufer 51, D-3000 Hannover 21 (DE)**

(72) Erfinder: **Gummelt, Klaus, Schulstrasse 2A, D-3008 Garbsen 1 (DE)**
Erfinder: **Schulz, Jürgen, Dr., Am Kreuzstück 19, D-6274 Hünstetten 2 (DE)**
Erfinder: **Salamon, Klaus, Dr., Am Waldeck 16, D-6233 Kelkheim (DE)**
Erfinder: **Rabenstein, Heinrich, Rombergstrasse 29, D-6000 Frankfurt 80 (DE)**

(74) Vertreter: **Kaiser, Dieter Ralf, Dipl.-Ing., Gundelhardtstrasse 72, D-6233 Kelkheim/Ts. (DE)**

# Beschreibung

Die Erfindung betrifft eine Vorrichtung zur Anzeige des Volladezustandes eines elektrischen Akkumulators, insbesondere Bleiakkumulators, welche aus einem temperaturempfindlichen elektronischen Bauelement zur Erfassung der Temperatur eines Rekombinationskatalysators besteht.

Sowohl eine zu starke als auch eine zu schwache Dosierung der Ladeströme sind für Bleiakkumulatoren lebensdauerschädlich. Bei Starterbatterien wird die Ladung im allgemeinen über die Spannung gesteuert. Diese ist jedoch kein eindeutiges Signal für den Volladezustand, da sie u.a. vom Alterungszustand der Batterie beeinflußt wird.

Mit Sicherheit hingegen ist eine Bleibatterie immer dann vollgeladen, wenn an der positiven und negativen Elektrode sich Sauerstoff und Wasserstoff in stöchiometrischem Verhältnis entwickeln. Dieses Ereignis steht dicht bevor, wenn sich an einer wasser- und sauerstoffrekombinierenden katalytischen Vorrichtung eine Erwärmung bemerkbar macht. Man hat daher ein solches Temperatursignal bereits dazu benutzt, um regelnd in den Ladevorgang einzugreifen.

Nach DE-A-26 38 899 fehlen einer Bleibatterie zum Zeitpunkt des Beginns der Gasung noch etwa 10% der bis zur Volladung aufzuwendenden Strommenge. Man ergänzt diese durch einen Nachladestrom, dessen Dauer und Stärke in ein vorwählbares Verhältnis zu den Parametern des ursprünglichen Stromes gesetzt sind, wobei der Temperaturanstieg an einer Rekombinationsvorrichtung als Regelgröße den Umschaltzeitpunkt von der Hauptladephase zur Nachladephase bestimmt.

Aus der DE-A-30 20 606, die eine Datensammeleinrichtung für ein Automobil betrifft, ist es ebenfalls bekannt, daß ein von einem katalytischen Umwandler abgegebenes Temperatursignal neben einem Batteriespannungssignal in eine Steuerschaltung eingegeben wird.

Schließlich ist es allgemein bekannt, das Heißwerden eines Rekombinationskatalysators, welchen man im Gasraum der Akkumulatorenzelle angeordnet hat, durch einen in dessen Nähe befindlichen Temperatursensor zu registrieren, wobei der Sensor als temperaturempfindliches Glied in einem mit dem Ladegerät verbundenen elektronischen Regelkreis, sei es durch Änderung seines Widerstandes oder einer Spannung, die Balance dieses Regelkreises aufhebt und die Abschaltung des Ladegerätes veranlaßt (GB-A-2 042 242, DE-A-3 018 305). Darüber hinaus offenbart die US-A-3 102 220 in einer Figurendarstellung auch die Struktur des eigentlichen Anzeigeelements, welches im Innern einer für die Akkumulatorgase durchlässigen Schutzkapsel ein Katalysatormaterial enthält, während der Außenseite der Schutzkapsel ein sogenannter Thermistor aufsitzt. Seine elektrischen Anschlüsse sind wiederum mit einem transistorgesteuerten Regelkreis für eine Ladestromquelle verbunden.

Der Erfindung liegt die Aufgabe zugrunde, eine auf Basis der Gasrekombination und mit Hilfe eines elektronischen Bauelements arbeitende Vorrichtung anzugeben, die es gestattet, eine durch Rekombination ausgelöste Wärmetönung ohne größeren Meßaufwand prompt zu erfassen und in ein vom Spannungsregler aufnehmbares Signal umzuwandeln.

Die Aufgabe wird erfindungsgemäß dadurch gelöst, daß die Oberfläche des Bauelements zumindest teilweise mit Katalysatormaterial beschichtet und den Akkumulatorgasen ausgesetzt ist.

Grundsätzlich erfüllt eine ganze Reihe elektronischer Bauelemente den erfindungsgemäßen Zweck. Als Beispiele seien genannt: Temperaturempfindliche Dioden, Transistoren, Thermistoren oder Heißleiter, das sind Halbleiter, deren elektrischer Widerstand in dem Sinne von der Temperatur abhängt, daß sie in heißem Zustande besser leiten, in kaltem Zustande schlechter, die im umgekehrten Sinne wirkenden sog. Kaltleiter, ferner die auf der Basis schlechtleitender Kupfer-Nickel-Legierungen (Konstantan) aufgebauten Thermoelemente oder ein als «Platin 100» bezeichneter Platinwiderstand, der bei 100°C einen definierten Widerstand von 20 Ω besitzt. Eine Einschränkung des Gebrauchs solcher thermoelektrischer «Sensoren» ist jedoch häufig durch eine chemisch-aggressive Umgebung geboten.

Erfindungsgemäß mit besonderem Vorteil einsetzbar ist ein Heißleiter, charakterisiert durch wachsende Elektronendurchlässigkeit bei steigender Temperatur, auch NTC-Leiter (Negative Temperature Coefficient) genannt. Ein alternativ verwendbarer Kaltleiter (PCT) wirkt umgekehrt bei erhöhter Temperatur wie ein elektrischer Widerstand und schaltet demgemäß bei Einsetzen der Rekombinationsreaktion den Ladestrom ab. Dabei ist es besonders vorteilhaft, an den PCT-Leiter eine bestimmte Grundheizung anzulegen, die dafür sorgt, daß der Rekombinationskatalysator stets trocken bleibt und daß er bei Ladeschluß ohne Verzögerung anspringt.

Die Beschichtung dieser Bauteile mit der katalytisch wirksamen Substanz kann auf mehreren Wegen erfolgen. Jedoch ist stets darauf zu achten, daß zumindest ein sich zwischen den Kontaktstellen erstreckender Oberflächenbereich von metallischleitendem Material, insonderheit dem vorzugsweise verwendeten Palladium-Katalysator freigehalten wird, um die Ausbildung einer Kurzschlußbrücke zu verhindern. Diese Gefahr ist beispielsweise bei einer galvanischen Aufbringung des Edelmetalls gegeben, wenn nämlich die Abscheidung unter Bedingungen geschieht, die eine hohe Keimbildungsrate begünstigen, d.h. hohe Stromdichte, hohe Badkonzentration, hohe Temperatur. In diesem Fall empfiehlt sich eine Maskierung des besagten Flächenbereichs mit einem Lack.

Anderen Verfahren der Katalysatoraufbringung geht zweckmäßig eine Beschichtung des Heiß- bzw. Kaltleiters mit einem nichtleitenden Kunststoff voraus.

Es ist weiterhin vorteilhaft, die katalysatorhaltige Schicht wiederum mit einer antimonadsorbierenden Schicht abzudecken, um eine frühzeitige Vergiftung des Katalysators durch Aufnahme von Antimon aus dem mit den Akkumulatorgasen unvermeidbar mitgeführten Antimonwasserstoff zu verhindern. Als besonders wirksames Adsorptionsmittel kommt Aktivkohle in Frage. Die Aktivkohle kann auch eigentliche Trägersubstanz für den Edelmetallkatalysator sein. Die zusätzliche Aktivkohleschicht stellt ferner eine Diffusionssperre zur Verhinderung von Explosionen (Zünddurchschlagsperre) dar.

Die erfindungsgemäße Katalysatorbeschichtung eines Heißleiters wird im folgenden anhand zweier Beispiele näher erläutert.

## Beispiel 1

Der Heißleiter wird in einem ersten Schritt durch Tauchung in ein Kunstharz mit einer dünnen Isolierschicht überzogen. Alternativ ist auch die Aufbringung von z.B. PTFE oder PVC in Form eines Sprays möglich.

In einem zweiten Schritt wird der Heißleiter in eine Paste getaucht, die durch Anrühren einer Mischung aus 75 g Aktivkohle und 25 g PTFE mit 100 ml $H_2O$ unter Zugabe von 10 ml einer 5%igen $PdCl_2$-Lösung hergestellt wurde. Eine Kontaminierung des Bereichs um die Kontaktstellen herum wird dabei vermieden.

Der dritte Schritt besteht in einer Tauchung des Heißleiters in ein stark reduzierendes Medium, beispielsweise eine Natriumboranat-Lösung. Dabei scheidet sich Pd in sehr feiner Verteilung ab.

Als vierter Schritt folgt gegebenenfalls eine Tauchung des Heißleiters in einen Aktivkohlebrei, der beispielsweise aus 100 g Aktivkohlepulver und 160 ml einer 0,7%igen wässrigen Carboximethylcellulose (Tylose)-Lösung angesetzt ist. Nach anschließender Trocknung, etwa 2 h bei 110 °C, ist der erfindungsgemäße Heißleiter gebrauchsfertig.

## Beispiel 2

Der Heißleiter wird gemäss Beispiel 1, Schritt 1, mit einer Kunststoffschicht überzogen.

Separat hiervon wird eine Mischung aus 100 g Aktivkohle, 135 ml Wasser und 11 ml einer 5%igen $PdCl_2$-Lösung hergestellt und zur Reduktion des $PdCl_2$ mit 10 ml einer 30%igen Natronlauge versetzt, in der 0,5 g Natriumboranat gelöst sind. In diesen Brei wird der Heißleiter unter Freilassung des Bereichs um die Kontaktstellen eingetaucht und somit das Katalysatormaterial in bereits aktiviertem Zustand aufgetragen. Es folgt eine Trocknung bei 100 °C.

## Beispiel 3

Das katalysatorhaltige Beschichtungsmaterial wird in Form einer Pille auf den kunststoffüberzogenen Heißleiter aufgeklebt.

Figur 1 zeigt einen erfindungsgemäß präparierten NTC-Leiter, stark vergrößert.

Figur 2 zeigt einen Verschlußstopfen mit durchgeführtem NTC-Leiter.

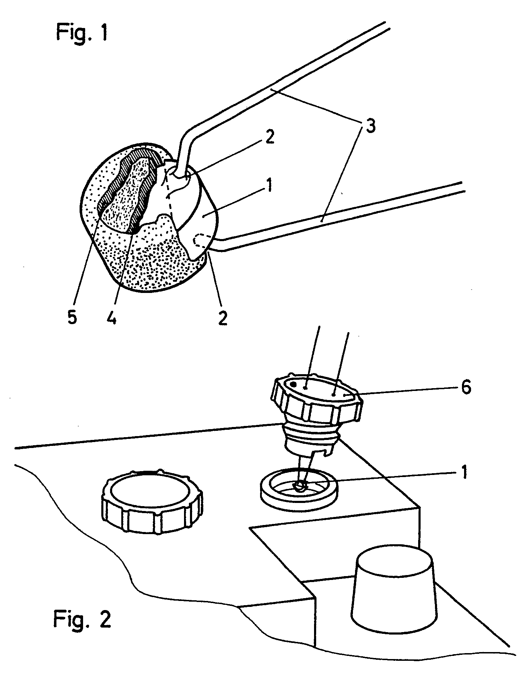

Eine handelsübliche Ausführungsform des NTC-Leiters ist die eines Flachzylinders von 4 mm ⌀ und 1,5 mm Höhe, an dessen Ober- und Unterseite die Anschlußdrähte angepetzt sind. Gemäß Figur 1 ist dieser originale und nur mit einem dünnen Kunststoff- oder Lacküberzug bedeckte Heißleiter 1 im ganzen Bereich um die Austrittsstellen 2 der Anschlußdrähte 3 von Katalysatormetall freigehalten, um eine Bildung von Kurzschlußbrücken zu verhindern. Der übrige Teil des Heißleiters trägt erfindungsgemäß eine Kohle/Palladium-Schicht 4, welche wiederum von einer antimonadsorbierenden Aktivkohleschicht 5 abgedeckt ist.

Für die richtige Plazierung des erfindungsgemäßen temperaturempfindlichen Bauelements im Akkumulator ist lediglich eine gute Zutrittsmöglichkeit der Ladegase wichtig, wobei jedoch Säurenebel ferngehalten werden sollten. Gemäß Figur 2 ist beispielsweise der Heißleiter zweckmäßig unterhalb eines Entgasungsstopfens 6 mit Durchführungen für die Anschlußdrähte angebracht. Die Anschlußdrähte führen zu einem – nicht gezeigten – Laderegler. Besonders günstig lassen sich erfindungsgemäße NTC-Leiter auch in Gassammelleitungen, an welche viele im Batterieverbund stehende Akkumulatorenzellen häufig angeschlossen sind, anordnen.

Die Kombination von Rekombination und Temperaturanzeige in einem kleinen Bauteil hat den Vorteil, daß sie sehr kostengünstig zu fertigen ist und vor allem, daß dieses Bauteil in seinem Einsatz sehr platzsparend ist. Von gleicher Bedeutung ist die Tatsache, daß aufgrund der geringen Wärmekapazität und der kleinen Wärmeübergangswiderstände zwischen Rekombinationselement und temperaturempfindlichen Bauelement die Ansprechzeiten sehr kurz sind.

## Patentansprüche

1. Vorrichtung zur Anzeige des Volladezustandes eines elektrischen Akkumulators, insbesondere Bleiakkumulators, welche aus einem temperaturempfindlichen elektronischen Bauelement zur Erfassung der Temperatur eines Rekombinationskatalysators besteht, dadurch gekennzeichnet, daß die Oberfläche des Bauelements (1) zumindest teilweise mit Katalysatormaterial (4) versehen und den Akkumulatorgasen ausgesetzt ist.

2. Vorrichtung nach Anspruch 1, dadurch gekennzeichnet, daß das elektronische Bauelement ein temperaturempfindlicher Widerstand ist.

3. Vorrichtung nach den Ansprüchen 1 und 2, dadurch gekennzeichnet, daß die katalysatorhaltige Schicht mit einer weiteren, antimonadsorbierenden Schicht abgedeckt ist.

4. Vorrichtung nach Anspruch 3, dadurch gekennzeichnet, daß die antimonadsorbierende Schicht aus Aktivkohle besteht.

## Claims

1. An apparatus for indicating the fully charged state of an electrical accumulator, in particular a lead accumulator, which comprises a temperature-sensitive electronic element for detecting the temperature of a recombination catalyst, characterized in that the surface of the element (1) is provided at least in part with catalyst material (4) and is exposed to the storage battery gases.

2. An apparatus according to Claim 1, characterized in that the electronic element is a temperature-sensitive resistor.

3. An apparatus according to Claims 1 and 2, characterized in that the catalyst-containing layer is covered with an additional antimony-adsorbing layer.

4. An apparatus according to Claim 3, characterized in that the antimony-adsorbing layer consists of activated carbon.

## Revendications

1. Dispositif pour indiquer l'état de pleine charge d'un accumulateur électrique, notamment d'un accumulateur au plomb, dispositif constitué d'un composant électronique sensible à la température pour détecter la température d'un catalyseur de recombinaison, dispositif caractérisé en ce que la surface du composant (1) est revêtue au moins partiellement par le matériau du catalyseur (4) et est exposée aux gaz de l'accumulateur.

2. Dispositif selon la revendication 1, caractérisé en ce que le composant électronique est une résistance sensible à la température.

3. Dispositif selon les revendications 1 et 2, caractérisé en ce que la couche contenant le catalyseur est recouverte d'une autre couche absorbant l'antimoine.

4. Dispositif selon la revendication 3, caractérisé en ce que la couche absorbant l'antimoine est constituée par du charbon actif.

0 161 398

Fig. 1

Fig. 2

5